# EUROPEAN PATENT APPLICATION

(11) **EP 1 863 181 A1**
(43) Date of publication of application: **05.12.2007**
(21) Application number: 06114816.9
(22) Date of filing: 01.06.2006
(51) Int. Cl.: H03M 13/29

(54) **Data Detection With Adaptive Reference Levels**

(71) Applicant: DEUTSCHE THOMSON-BRANDT GMBH, 78048 Villingen-Schwenningen (DE)
(72) Inventor: Hölzemann, Herbert, 78048 Villingen (DE); Müller, Stefan, 78048 Villingen (DE); Schmitt, Dirk, 78176 Blumberg (DE)
(74) Representative: Schmidt-Uhlig, Thomas

(57) **Abstract**

The present invention relates to data detection with adaptive reference levels based on reliability estimations, and to storage systems and systems for receiving digital data using such data detection.

According to the invention, a method for adapting the reference levels of a detector (2) is characterized in that the adaptation rate of the reference levels is determined by the reliability of the detected code words.

## Description

The present invention relates to data detection with adaptive reference levels based on reliability estimations, and to storage systems and systems for receiving digital data using such data detection.

Maximum likelihood detection is an established approach for achieving an improved bit error rate (BER) at low signal to noise ratios (SNR). Maximum likelihood detection is often employed in optical disk systems or data transmission systems. However, its effectiveness is limited by the Euclidean distance between the received code word and the given reference levels. Hence a proper choice of reference levels greatly improves the detection performance. A main problem of maximum likelihood detection is the determination of the best reference values even in case of bad or changing channel conditions, e.g. asymmetry, noise, or other distortion (e.g. black dot or scratch etc. on an optical disk). Other detection schemes based on adaptive reference levels are known, using for example a slicer or a MAP detector (Maximum a Posteriori).

A plurality of solutions for determining the reference levels are known. A first solution is to use fixed reference levels based on measurements or tests. This solution, however, is unable to react properly to a changing channel transfer function.

A further solution is to provide adaptive reference levels through low-pass filtering. This solution is described, for example, in Jpn. J. Appl. Phys. Vol. 41 (2002) pp. 1789-1790: Adaptive Partial-Response Maximum Likelihood Detection in Optical Recording Media*.* In this case the use of fixed coefficients for the low-pass filter results in a coarse quantization of the reference levels.

Still a further solution is described in JP 2002-217860. According to this so-called pilot averaging solution a pilot channel is used for estimating the channel response for all other channels. The solution is only applicable to OFDM systems (Orthogonal Frequency Division Multiplex), because in these systems the channel response is not fixed. The pilot channel can be fixed or randomly connected to a sub frequency of the OFDM system. For the whole channel response (all sub channels) an interpolation of the channel response of each pilot channel is made. The better the estimation of the pilot channel, the better is the estimation of the whole channel response and the better is the estimation of the OFDM symbols used for demapping. In JP 2002-217860 the reliability and dependability signal is used for improving the estimation of the pilot channel. Modulation techniques, which are addressed in this document, are QPSK (Quadrature Phase Shift Keying) and QAM (Quadrature Amplitude Modulation).

It is an object of the invention to propose a further solution for adapting the reference levels for data detection.

According to the invention, this object is achieved by a method for adapting the reference levels of a detector, wherein the adaptation rate of the reference levels is determined by the reliability of the detected code words.

Furthermore, this object is also achieved by a data detection system having a detector with adaptive reference levels, wherein the adaptation rate of the reference levels is determined by the reliability of the detected code words.

The invention proposes a fine adjustment of the reference levels for a detector, e.g. a maximum likelihood detector, a slicer, or a maximum a posteriori detector, by using reliability estimations for each code word. The solution has the advantage that the reference levels are optimally adapted to changing channel conditions such as asymmetry or amplitude level fluctuations. The method has a high resistance against noise and other types of distortions (e.g. black dots, silver dots, scratches, or finger prints on an optical disk). At the same time the hardware complexity of the data detection system is only slightly increased.

In comparison to the above pilot averaging solution, which is only applicable for time variant, frequency division channels, the proposed solution is especially suitable for time invariant, baseband channels. For a time invariant channel, no channel response estimation is necessary. Furthermore, the pilot averaging solution uses a pilot channel (i.e. symbols, not bits) for estimation of the channel response and hence for adjustment of the demapping levels. In contrast, the proposed solution uses all transmitted symbols (bits) for the reference level adaptation.

Advantageously, the adaptation rate is high when the reliability of the detected code words is high, and the adaptation rate is low when the reliability of the detected code words is low. In this way the suppression of disturbances in reference level adaptation is enabled.

Preferably, the reference levels are either directly adapted by a reference level adaptation block, or indirectly adapted by adapting filter coefficients of a low-pass filter used for providing adaptive reference levels.

The reliability information is preferably calculated by the detector, e.g. a Soft-In/Soft-Out (SISO) decoder. This allows an optimal adaptation of the signal levels to changing channel characteristics and distortions.

Preferably, the method according to the invention is used in an apparatus for reading from and/or writing to recording media, e.g. optical recording media. For optical recording media no pilot channel is available for channel estimation. In such a case the method according to the invention still allows for a reliable adjustment of the reference levels. Of course, the method is likewise applicable for other types of recording media, such as magnetic recording media. Basically, the solution is applicable to all types of systems for receiving digital data.

For a better understanding the invention shall now be explained in more detail in the following description with reference to the figures. It is understood that the invention is not limited to this exemplary embodiment and that specified features can also expediently be combined and/or modified without departing from the scope of the present invention. In the figures:
- Fig. 1: shows a block diagram of a maximum likelihood detection system with adaptive reference levels,
- Fig. 2: illustrates the behavior of the reference levels using low-pass filtering with a too small time constant,
- Fig. 3: illustrates the behavior of the reference levels using low-pass filtering with a too large time constant,
- Fig. 4: shows the behavior of the reference levels on a noisy channel using the low-pass filter solution with a fixed time constant,
- Fig. 5: depicts the reference levels under the conditions of Fig. 4, but using an adaptation based on reliability information,
- Fig. 6: depicts the reference levels in case of a black dot distortion using the normal low-pass adaptation,
- Fig. 7: shows a zoomed portion of Fig. 6,
- Fig. 8: depicts the reference levels in case of a black dot distortion using the adaptation based on reliability, and
- Fig. 9: shows a zoomed portion of Fig. 8.

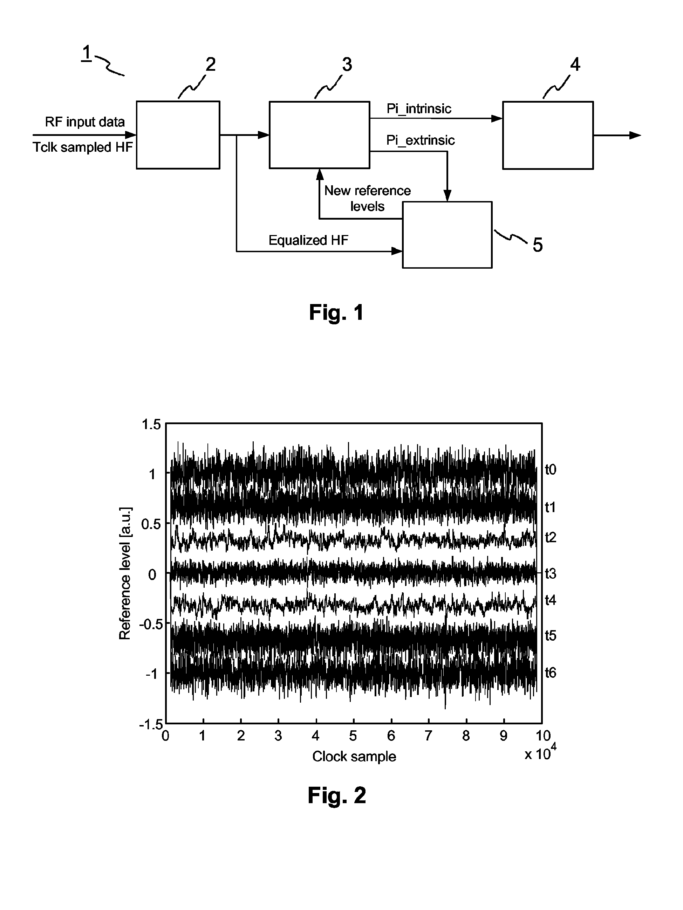

Fig. 1 shows a block diagram of a maximum likelihood detection system 1 with adaptive reference levels as an example of a data detection system. RF input data are equalized by an adaptive equalizer 2 and fed to a Soft-In/Soft-Out (SISO) maximum likelihood detector 3. The maximum likelihood detector 3 outputs reliability data Pi_intrinsic and Pi_extrinsic. For determining the reliability data different methods may be used, e.g. MAP (Maximum a Posteriori), log MAP, max log MAP, or SOVA (Soft Output Viterbi Algorithm). In essence, any reliability determining method can be employed. The Pi_intrinsic data are fed to a demodulation and error correction block 4, which then decides which binary value was finally received. The Pi_extrinsic data are fed to a reference level adaptation block 5 to adjust the reference levels of the maximum likelihood detector 3 based on the reliability of the received data and the equalized HF-signal.

One reason to make the reference levels adjustable is to be capable to react properly to changing channel conditions, e.g. asymmetry, amplitude level fluctuations, noise, and other distortions. Typical distortions in case of optical disks are black dots, scratches etc. When fixed reference levels are used, the detection is likely to fail or at least the performance degrades.

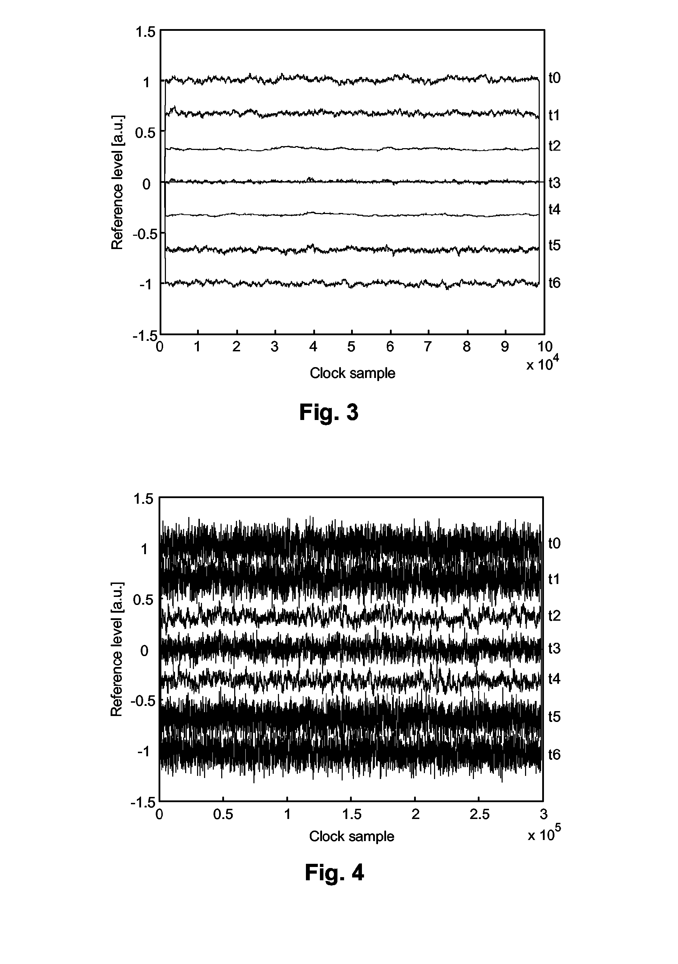

The known adaptive solution based on low-pass filtering improves the detection. However, a drawback of this solution is the non-adaptive time constant of the filter. A time constant which is chosen too small results in very noisy and unstable reference levels for the maximum likelihood detector 3 under noisy channel conditions. This is illustrated in Fig. 2, in which simulated reference levels are plotted against the clock samples. If the time constant is chosen too large, this results in a very inflexible filter and, therefore, in almost fixed reference levels with their described disadvantages. A simulated example of this case is illustrated in Fig. 3. In the figures, the reference levels return to '0' at the end of the simulation. This is caused by the simulation and does not occur in a real system.

Consequently, an important problem is to determine the right value of adaptation for a given signal-to-noise ratio, or in case of the low-pass filtering solution, the choice of a proper time constant. The invention solves this problem by using the reliability information Pi_extrinsic calculated by the maximum likelihood detector 3 for continuously adapting the reference levels.

The idea is to have a high and fast adaptation when the reliability is high, and to have a slow or even no adaptation when the reliability is low. This enables a very fast and stable adjustment of the reference levels under good channel conditions and in case of certain operation modes, e.g. after a jump or at startup. At the same time the reference levels are less susceptible to noise and other distortions, like black or silver dots, scratches or fingerprints.

In Fig. 4 a simulation of the behavior of the reference levels on a noisy channel (SNR=8dB) using the low-pass filter solution with a fixed time constant is shown. All reference levels are very unstable. Furthermore, they are not always distinguishable.

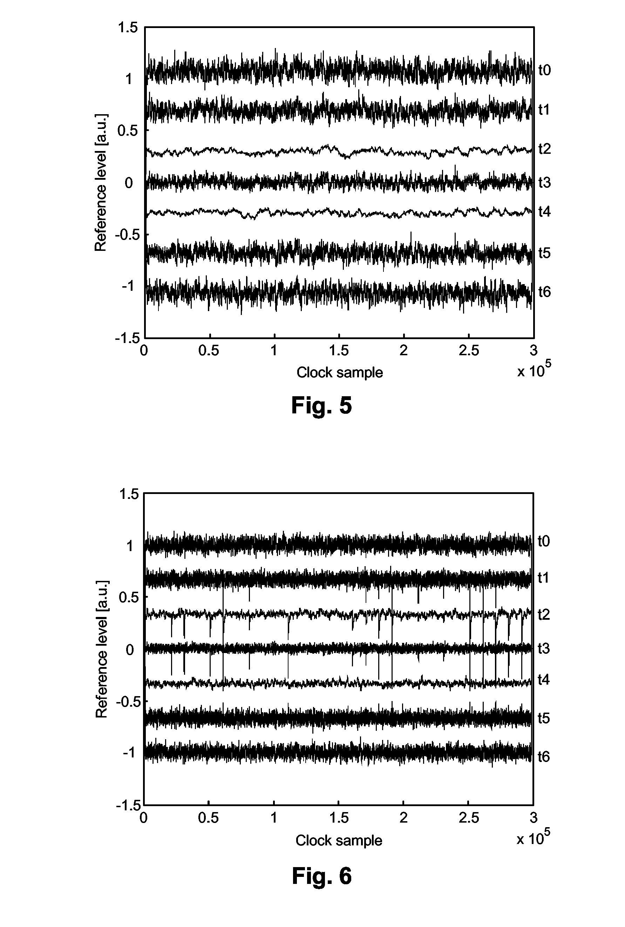

Fig. 5 shows a simulation of the same reference levels under the same conditions but using an adaptation based on reliability information according to the invention. In this case the reference level curves are flatter, i.e. more settled than in Fig. 4, and there always is a clear separation between two reference levels.

Another simulated example is given in Figs. 6 to 9 for the case of an optical recording medium. Fig. 6 depicts the reference levels in case of a plurality of black dot distortions using the normal low-pass adaptation. In the simulation the black dots manifest as spikes in some of the reference level curves, especially the curves for t1, t2, and t3. Of course, also the other reference levels can be affected by the black dots.

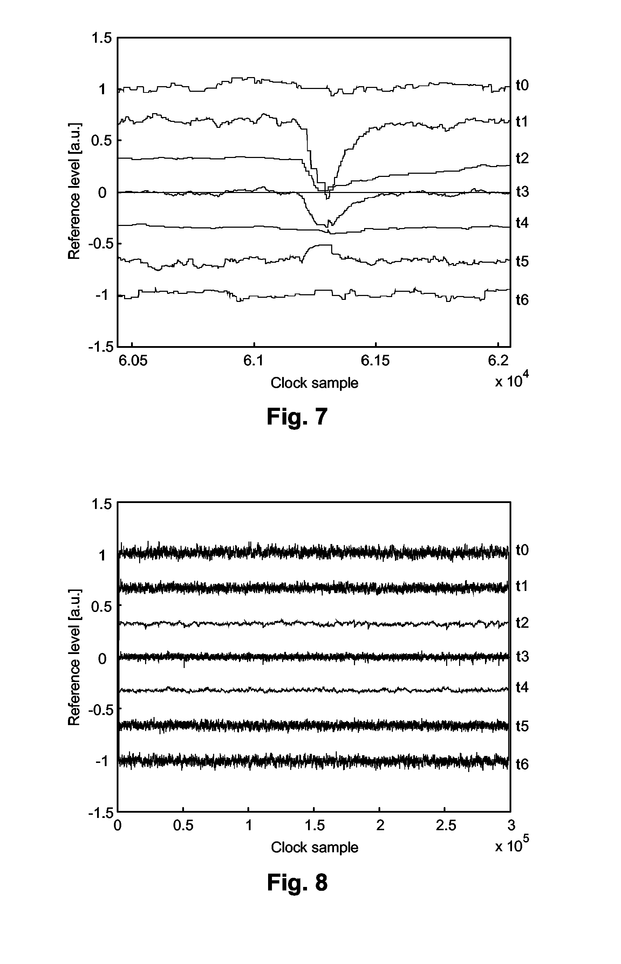

Fig. 7 shows a zoom into Fig. 6. In this zoom a selected single signal collapse due to a black dot is seen, followed by a slow new adaptation to the old value. The time needed for the new adaptation of course depends on the employed time constant.

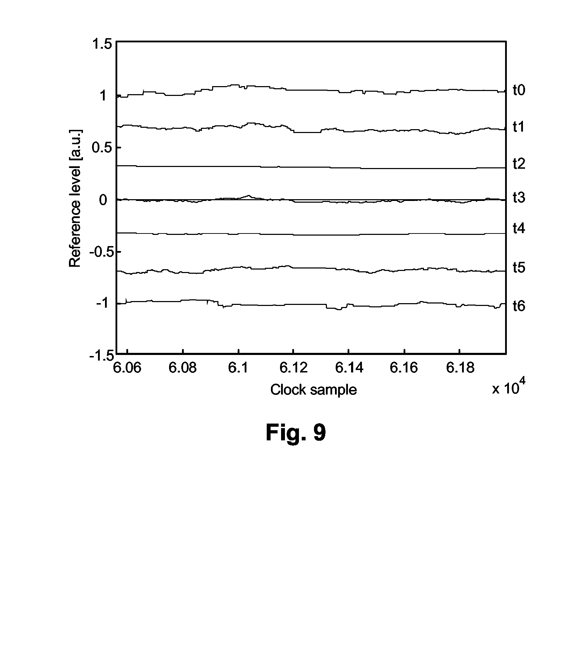

In contrast there is no distortion at all using the proposed adaptation based on reliability. At the occurrence of the black dot the reliabilities of the received code words are very low, so that no or only a very small adjustment is performed. This is illustrated in Fig. 8 and Fig. 9. As can be seen in Fig. 8, only in the reference level t3 some very small spikes occur. There is no complete dropout. This can be seen even better in Fig. 9, which shows a zoom into Fig. 8. The results are similar for other distortions like scratches or noise, which affect the reference levels as well.

## Claims

1. Method for adapting the reference levels of a detector (2) with adaptable reference levels, **wherein** the adaptation rate of the reference levels is determined by the reliability of the detected code words.

2. Method according to claim 1, **wherein** the reference levels are directly adapted by a reference level adaptation block (3) or indirectly adapted by adapting filter coefficients of a low-pass filter used for providing adaptive reference levels.

3. Method according to claim 1 or 2, **wherein** the adaptation rate is high when the reliability of the detected code words is high, and the adaptation rate is low when the reliability of the detected code words is low.

4. Method according to one of claims 1 to 3, **wherein** the reliability of the detected code words is estimated by the detector (2).

5. Method according to one of claims 1 to 4, **wherein** the detector (2) is one of a maximum likelihood detector, a slicer, or a maximum a posteriori detector.

6. Data detection system (1), with a detector (2) with adaptive reference levels, **wherein** the adaptation rate of the reference levels is determined by the reliability of the detected code words.

7. Data detection system (1) according to claim 6, **including** a reference level adaptation block (3) for directly adapting the reference levels or a filter coefficient adaptation block for adapting filter coefficients of a low-pass filter used for providing adaptive reference levels.

8. Data detection system (1) according to claim 6 or 7, **wherein** the adaptation rate is high when the reliability of the detected code words is high, and the adaptation rate is low when the reliability of the detected code words is low.

9. Data detection system (1) according to one of claims 6 to 8, **wherein** the reliability of the detected code words is estimated by the detector (2).

10. Data detection system (1) according to one of claims 6 to 9, **wherein** the detector (2) is one of a maximum likelihood detector, a slicer, or a maximum a posteriori detector.

11. Apparatus for reading from and/or writing to recording media, **characterized in that** it is adapted for performing a method according to one of claims 1 to 5 or includes a data detection system (1) according to one of claims 6 to 10.

12. Apparatus for receiving digital data, **characterized in that** it is adapted for performing a method according to one of claims 1 to 5 or includes a data detection system (1) according to one of claims 6 to 10.
